# EUROPÄISCHE PATENTSCHRIFT

(11) **EP 0 789 945 B1**
(45) Veröffentlichungstag und Bekanntmachung des Hinweises auf die Patenterteilung: **02.06.1999**
(21) Anmeldenummer: 95935915.9
(22) Anmeldetag: 07.10.1995
(51) Int. Cl.: H02B 1/34

(54) **SCHALTSCHRANK**
SWITCHGEAR CABINET
ARMOIRE DE DISTRIBUTION

(30) Priorität: 05.11.1994 DE 4439692
(43) Veröffentlichungstag der Anmeldung: 20.08.1997
(73) Patentinhaber: Rittal-Werk Rudolf Loh GmbH & Co. KG, 35745 Herborn (DE)
(72) Erfinder: HARTEL, Marc, D-35447 Reiskirchen (DE); ZACHRAI, Jürgen, D-35690 Dillenburg (DE)
(74) Vertreter: Fleck, Hermann-Josef, Dr.-Ing.
(86) Internationale Anmeldenummer: EP9503962
(87) Internationale Veröffentlichungsnummer: WO9614681

(56) Entgegenhaltungen:
- FR-A- 2 374 819
- FR-A- 2 681 478

## Beschreibung

Die Erfindung betrifft einen Schaltschrank mit einem aus Rahmenschenkeln zusammengesetzten Gestellrahmen, der mittels eines Deckels, Seitenteilen, einer Rückwand und einer Schranktür verschließbar ist und wobei die horizontalen Tiefenstreben als nach außen offene Profilabschnitte ausgebildet sind.

Ein solcher Schaltschrank ist aus der FR 2 682 478 bekannt. Dabei ist ein Gestellrahmen verwendet, der aus zwölf Rahmenschenkeln zusammengesetzt ist. Diese sind an ihren aufeinanderstoßenden Enden mittels Eckverbindern miteinander verbunden. Zur Verkleidung des Gestellrahmens können die Seitenwände, der Deckel und die Rückwand an den Rahmenschenkeln befestigt werden.

Aus der FR 2 374 819 ist ein Schaltschrank bekannt, dessen Gestellrahmen aus stranggepreßten Profilabschnitten zusammengesetzt ist. Die Profilabschnitte weisen eine hinterschnittene in Profillängsrichtung verlaufende Aufnahmenut auf, die zum Schaltschrankinnenraum gerichtet ist. In die Aufnahmenuten können Muttern eingeschoben werden. An diesen lassen sich Anbauten befestigen.

Es ist Aufgabe der Erfindung, einen Schaltschrank der eingangs erwähnten Art zu schaffen, dessen Konstruktion wesentlich vereinfacht wird, wobei in den Eckbereichen optische und funktionelle Elemente auf einfache Weise festlegbar sind.

Die Aufgabe der Erfindung wird dadurch gelöst, daß der Deckel und/oder die Seitenteile Abkantungen aufweisen, die die Außenseite der Profilabschnitte zumindest teilweise überdecken, wobei mit der Abkantung und der Außenseite eine Aufnahme ausgebildet ist, in die ein Steckansatz eines Eckstückes einsetzbar ist.

In der Aufnahme im Bereich zwischen der Tiefenstrebe und der Abkantung des Deckels oder der Seitenwand kann ein Eckstück angebracht und anschließend fixiert werden. Die Aufnahme übernimmt damit neben der Festlegung des Eckstückes auch eine Positionierungsfunktion, die eine exakte Ausrichtung des Eckstückes erlaubt. Das Eckstück selbst kann zur Erfüllung der einzelnen optischen und funktionellen Anforderungen entsprechend ausgestaltet sein.

Nach einer Ausgestaltung der Erfindung ist vorgesehen, daß die Tiefenstrebe als ein Winkelprofil mit zwei Schenkeln ausgebildet ist, an die ein horizontaler und ein vertikaler Rahmenschenkel angeschlossen ist, und daß der Deckel die Abkantung aufweist, die sich zu den beiden Enden der Schenkel erstreckt, so daß zwischen der Abkantung und den beiden Schenkeln des Winkelprofiles eine im Querschnitt dreieckförmige Aufnahme gebildet ist.

Die Rahmenschenkel können einfach an die Tiefenstrebe angeschraubt werden. Hierzu sind in der Tiefenstrebe Schraubaufnahmen aufgebracht, in die Befestigungsschrauben einführbar und in Gewindeaufnahmen der Rahmenschenkel einschraubbar sind. Zur Überdeckung der Schraubenköpfe kann das Eckstück dienen. Das Eckstück selbst wird dann in der dreieckförmigen Aufnahme mit seinem ebenfalls dreieckförmigen Steckansatz unverdrehbar festgelegt.

Eine bevorzugte Ausgestaltung der Erfindung sieht vor, daß zumindest ein oberes und ein unteres Eckstück einer zugeordneten Seite des Gestellrahmens einen Basiskörper im Anschluß an den Steckansatz aufweisen, der über die Schaltschrankvorderseite vorgezogen ist und mit Aufnahmen oder Ansätzen für eine Türscharnierung und/oder ein Schließgestänge versehen sind. Soll die Türscharnierung beispielsweise auf der anderen Seite des Gestellrahmens erreicht werden, so werden lediglich die Eckstücke auf die andere Seite getauscht. Die Tür kann dann um 180° verdreht an diesen Eckstücken festgelegt werden. Es ist auch möglich, auf einer Seite des Gestellrahmens mittels zweier Eckstücke die Türscharnierung und auf der anderen Seite die Aufnahme des Schließgestänges zu realisieren.

Um beispielsweise auf der Rückseite des Schaltschrankes einen optischen Abschluß zu erreichen, ist es aber auch möglich, daß die Basiskörper bündig mit der Vorder- bzw. der Rückseite des Gestellrahmens abschließen.

Ist vorgesehen, daß die Steckansätze der Eckstücke über Absätze in die Basiskörper übergehen, so ist die Einsetzbewegung der Eckstücke in die Aufnahmen begrenzbar. Hiermit läßt sich eine exakte Positionierung der Eckstücke erreichen. Dies ist vor allem für die Verbindung der Eckstücke zur Anscharnierung einer Tür oder zur Aufnahme des Schließgestänges von Bedeutung.

Zu Abdichtung des Schaltschrankes ist vorgesehen, daß in die Längsnuten der horizontalen und vertikalen Rahmenschenkel Dichtungen eingelegt sind, auf die die Ränder des Deckels und der Seitenteile pressen.

Zur Abdichtung der Rückwand und der Schaltschranktür kann zusätzlich vorgesehen sein, daß die horizontalen und die vertikalen Rahmenschenkel zur Vorderseite bzw. zur Rückseite des Gestellrahmens gekehrte Stirnflächen aufweisen, daß das Eckstück an seinem Basisteil im Bereich der Stirnfläche eine Ebene, in die beiden Stirnflächen übergehende Anschlußflächen aufweist und daß auf die Stirnfläche und die Anschlußflächen der Eckstücke umlaufende Dichtungen zur Abdichtung der Rückwand und/oder der Schranktür aufbringbar sind.

Ist das Eckstück derart ausgestaltet,- daß der die Außenflächen bildende Teil des Basiskörpers in die nach außen gekehrten Seitenflächen der angeschlossenen Rahmenschenkel übergeht, so ist im Eckbereich des Schaltschrankes ein optischer Abschluß erreicht.

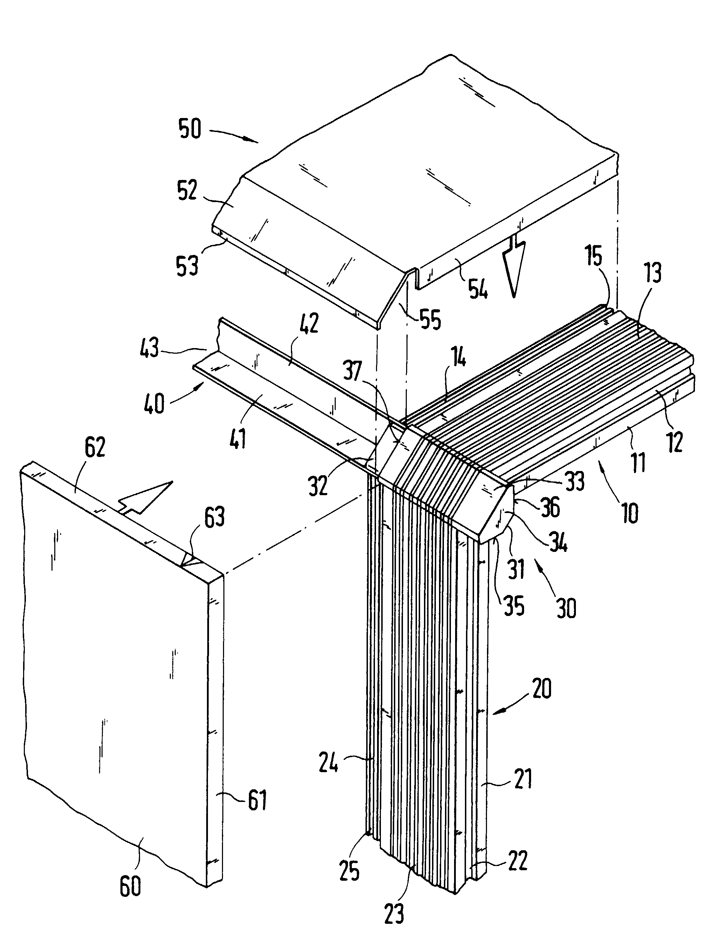

Die Erfindung wird im folgenden anhand eines in der Zeichnung dargestellten Ausführungsbeispieles näher erläutert.

Die Zeichnung zeigt in perspektivischer Explosionsdarstellung einen Eckbereich eines Gestellrahmens, an den ein Deckel 50 und eine Seitenwand 60 angeschlossen werden kann. Der Gestellrahmen ist aus horizontalen und vertikalen Rahmenschenkeln 10, 20 sowie aus Tiefenstreben 40 zusammengesetzt. Die horizontalen und die vertikalen Rahmenschenkel 10, 20 bilden zur Vorderseite und zur Rückseite des Schaltschrankes einen geschlossenen Rahmen. Diese beiden Rahmen sind über die Tiefenstreben 40 miteinander verbunden. Zur Verbindung der einzelnen Rahmenschenkel 10, 20 miteinander werden die Tiefenstreben 40 verwendet. Hierzu weisen diese Schraubaufnahmen auf. Fluchtend zu den Schraubaufnahmen der Tiefenstreben 40 sind in die Rahmenschenkel in Längsrichtung verlaufende Schraubaufnahmen eingebracht. Mittels Befestigungsschrauben, die in die Schraubaufnahmen der Tiefenstrebe eingesetzt und in die Längsgerichteten Schraubaufnahmen der Rahmenschenkel 10, 20 eingeschraubt werden, können diese an den Schenkeln 41, 42 der Tiefenstrebe verspannt werden. Die als Winkelprofil ausgebildete Tiefenstrebe 40 ist hierbei nach außen, dem Schaltschrankinnenraum abgekehrt, offen.

Die horizontalen und die vertikalen Rahmenschenkel 10, 20 sind gleich ausgebildet. Sie weisen eine zur Vorderseite bzw. zur Rückseite des Schaltschrankes gekehrte Stirnfläche 11, 21 auf, in die eine als Dichtungsaufnahme ausgebildete Längsgerichtete Nut 12, 22 eingebracht ist. Die Stirnfläche 11, 21 geht rechtwinklig in eine nach außen gekehrte Seitenfläche 13, 23 über. Die Seitenfläche ist mit Längsnuten versehen. Der Stirnfläche 11, 21 abgekehrt ist der Seitenfläche 13, 23 ein Absatz 14, 24 angeschlossen. Der Absatz 14, 24 weist eine Längsnut 15, 25 auf. Die Absätze 14, 24 der Rahmenschenkel 10, 20 gehen bündig in die Enden der Schenkel 41, 42 der Tiefenstrebe 40 über. Der Nutgrund der Dichtungsaufnahmen 12, 22 der Stirnflächen 11, 21 schließen bündig mit der Stirnseite der Tiefenstrebe 40 ab.

Der so gebildete Gestellrahmen kann mittels eines Deckels 50, Seitenwänden 60, einer in der Zeichnung nicht dargestellten Rückwand sowie einer Schranktür verschlossen werden. Die Seitenwand 60 weist hierzu dem Schaltschrank zugekehrte abgekantete Ränder 61, 62 auf. Der Rand 61 des Seitenteils 60 ist in die Längsnut 25 eingesetzt. Um das Einsetzen zu ermöglichen, ist eine Aussparung 63 in dem Rand 62 vorgesehen. Diese Aussparung 63 übergreift den an die Längsnut anschließenden Steg.

Der obere Rand 62 des Seitenteiles 60 kommt unter dem horizontalen Schenkel 41 der Tiefenstrebe 40 zum liegen. Zur Abdichtung der Seitenwand sind zum einen in den Längsnuten 25 der vertikalen Rahmenschenkel 20 und zum anderen zwischen dem Rand 62 und dem Schenkel 41 Dichtungselemente angeordnet. Die Befestigung der Seitenteile 60 an dem Gestellrahmen erfolgt an den vertikalen Rahmenschenkeln 20 mittels im einzelnen nicht dargestellten Klemmschrauben.

Der Deckel 50 ist mit einem vorderen und einem hinteren Rand 54 versehen. Diese Ränder 54 greifen in die Längsnuten 15 der horizontalen Rahmenschenkel 10 ein. Zur Abdichtung können ebenfalls in den Längsnuten 15 Dichtungen eingelegt sein. Im Anschluß an die Deckelfläche geht der Deckel 50 in eine um 45° abgewinkelte Abkantung 52 über. Die Abkantung 52 erstreckt sich Ober die beiden Enden der Schenkel 41, 42 der Tiefenstrebe. Damit ist zwischen der Abkantung 52 und der Außenseite 43 der Tiefenstrebe 40 eine, im Querschnitt dreieckförmige Aufnahme ausgebildet. Die Aufnahme ist zur Vorder- und zur Rückseite des Schaltschrankes hin offen. Der Zugang zu der Aufnahme wird durch Ausklinkungen 55 des Deckels 50 erreicht.

Zur Überdeckung des horizontalen Schenkels 41 der Tiefenstrebe 40 ist von der Abkantung 52 des Deckels 50 ein vertikal nach unten gerichteter Ansatz 53 abgekantet.

In die Aufnahme, die zwischen der Abkantung 52 und der Tiefenstrebe 40 gebildet ist, kann ein Steckansatz 32 eines Eckstückes 30 eingesetzt werden. Der Steckansatz 32 ist mittels eines Absatzes 37 von einem Basiskörper 33 des Eckstückes 30 abgesetzt. Der Steckansatz 32 ist im Querschnitt dreieckförmig auf die Aufnahme angepaßt. Der Basiskörper selbst ragt über die Stirnflächen 11, 21 der horizontalen und vertikalen Rahmenschenkel 10, 20 vor. An den Schenkeln 41, 42 der Tiefenstrebe 40 legen sich die Anlageflächen 35, 36 des Eckstückes an. In die Anlagefläche 35 ist eine Aufnahme für ein Schließgestänge oder eine Scharnierung eingebracht. Beispielsweise zur Anscharnierung der Tür weisen ein oberes und ein unteres Eckstück 30 einer Seite des Gestellrahmens Aufnahmen auf, in die die Scharnierbolzen der Tür eintreten. Auf der anderen Seite des Gestellrahmens können dann zur Aufnahme der Schließbolzen entsprechend ausgebildete Eckstücke 30 angebracht sein. Soll nun die Scharnierachse auf die andere Seite des Gestellrahmens getauscht werden, so müssen lediglich die Eckstücke gewechselt werden.

Die Fixierung der Eckstücke erfolgt zum einen durch den Steckansatz 32 und zum anderen durch Schraubverbindungen mit der Tiefenstrebe 40 oder den Rahmenschenkeln 10, 20. Durch eine feste Anbindung der Eckstücke 30 wird zudem eine Aussteifung des Gestellrahmens erreicht.

Zur Abdichtung der anscharnierten Tür sind in nach vorne gekehrte Stirnflächen 34 der Eckstücke 30 Aussparungen angebracht. Die Aussparungen gehen in Anschlußflächen über, die mit den Stirnflächen 11, 21 bzw. dem Nutgrund der Dichtungsaufnahmen 12, 22 der Rahmenschenkel 10, 20 abschließen. Hierdurch können umlaufende Dichtungen beispielsweise auch HF-Dichtungen eingesetzt werden. An der Rückseite des Schaltschrankes können solche Eckstücke 30 eingesetzt werden, die bündig mit ihrer Stirnfläche 34 mit den Stirnflächen 11, 21 der Rahmenschenkel 10, 20 abschließen. Damit ist es auch einfach möglich, die Rückwand gegen die Schaltschranktür auszuwechseln. Hierzu müssen lediglich die Eckstücke 30 der Rückseite auf die Vorderseite und die Eckstücke 30 der Vorderseite entsprechend auf die Rückseite gewechselt werden. Das im Ausführungsbeispiel dargestellte Eckstück 30 weist eine geschrägte Fläche mit Längsnuten auf, die in die Längsnuten der Seitenflächen 13, 23 der Rahmenschenkel 10, 20 Obergehen. Hierdurch fügt sich das Eckstück 30 optisch in den Gestellrahmen ein, so daß der Eindruck eines nahtlosen Überganges der horizontalen in die vertikalen Rahmenschenkel entsteht.

## Patentansprüche

1. Schaltschrank mit einem aus Rahmenschenkeln zusammengesetzten Gestellrahmen, der mittels eines Deckels (50), Seitenteilen (60), einer Rückwand und einer Schranktür verschließbar ist und wobei die horizontalen Tiefenstreben (40) als nach außen offene Profilabschnitte ausgebildet sind,
dadurch gekennzeichnet,
daß der Deckel (50) und/oder die Seitenteile (60) Abkantungen (52) aufweisen, die die Außenseite (43) der Profilabschnitte zumindest teilweise überdecken, wobei mit der Abkantung (52) und der Außenseite (43) eine Aufnahme ausgebildet ist, in die einen Steckansatz (32) eines Eckstückes (30) einsetzbar ist.

2. Schaltschrank nach Anspruch 1,
dadurch gekennzeichnet,
daß die Tiefenstrebe (40) als ein Winkelprofil mit zwei Schenkeln (41,42) ausgebildet ist, an die ein horizontaler und ein vertikaler Rahmenschenkel (10 und 20) angeschlossen ist, und
daß der Deckel (50) die Abkantung (52) aufweist, die sich zu den beiden Enden der Schenkel (41,42) erstreckt, so daß zwischen der Abkantung (52) und der Außenseite (43) der beiden Schenkeln (41,42) des Winkelprofils (40) eine im Querschnitt dreieckförmige Aufnahme gebildet ist.

3. Schaltschrank nach einem der Ansprüche 1 bis 3,
dadurch gekennzeichnet,
daß zumindest ein oberes und ein unteres Eckstück (30) einer zugeordneten Seite des Gestellrahmens einen Basiskörper (33) im Anschluß an den Steckansatz (32) aufweisen, der über die Schaltschrankvorderseite vorgezogen ist und mit Aufnahmen oder Ansätzen für eine Türscharnierung und/oder ein Schließgestänge versehen sind, oder
daß die Basiskörper bündig mit der Vorder- bzw. der Rückseite des Gestellrahmens abschließen.

4. Schaltschrank nach einem der Ansprüche 1 bis 3,
dadurch gekennzeichnet,
daß die Steckansätze (32) der Eckstücke (30) über Absätze (37) in die Basiskörper (33) Obergehen.

5. Schaltschrank nach einem der Ansprüche 1 bis 4,
dadurch gekennzeichnet,
daß die horizontalen und vertikalen Rahmenschenkel (10,20) mit Längsnuten (15,25) versehen sind, in die abgekantete Ränder (54,61) des Deckels (50) und der Seitenteile (60) eingreifen.

6. Schaltschrank nach Anspruch 5,
dadurch gekennzeichnet,
daß in die Längsnuten (15,25) der horizontalen und vertikalen Rahmenschenkel (10,20) Dichtungen eingelegt sind, auf die die Ränder (54,61) des Deckels (50) und der Seitenteile (50) pressen.

7. Schaltschrank nach einem der Ansprüche 1 bis 6,
dadurch gekennzeichnet,
daß die horizontalen und die vertikalen Rahmenschenkel (10,20) zur Vorderseite bzw. zur Rückseite des Gestellrahmens gekehrte Stirnflächen (11,21) aufweisen, daß das Eckstück an seinem Basisteil (33) im Bereich der Stirnflächen (11,21) eine ebene, in die beiden Stirnflächen (11,21) übergehende Anschlußfläche aufweist, und
daß auf die Stirnflächen (11,21) und die Anschlußflächen der Eckstücke (30) umlaufende Dichtungen zur Abdichtung der Rückwand und/oder der Schranktür aufbringbar sind.

8. Schaltschrank nach einem der Ansprüche 1 bis 7,
dadurch gekennzeichnet,
daß der die Außenfläche(n) bildende Teil des Basiskörpers (33) des Eckstückes (30) in die nach außen gekehrten Seitenflächen (13,23) der angeschlossenen Rahmenschenkel (10,20) übergeht.

## Claims

1. Switchgear cabinet, including a framework, which comprises frame members and is closable by means of a cover (50), side panels (60), a rear wall and a cabinet door, and wherein the horizontal depth bars (40) are configured as outwardly open profile portions, characterised in that the cover (50) and/or the side panels (60) have bent-over portions (52), which at least partially cover the external surface (43) of the profile portions, the bent-over portion (52) and the external surface (43), forming a recess into which a plug-in member (32) of a corner piece (30) is insertable.

2. Switchgear cabinet according to claim 1, characterised in that the depth bar (40) is configured as an angular profile having two arms (41,42) which connect with a horizontal frame member and a vertical frame member (10 and 20), and in that the bent-over portion (52) of the cover (50) extends to the two ends of the arms (41,42), so that a recess, having a triangular cross-section, is formed between the bent-over portion (52) and the external surface (43) of the two arms (41,42) of the angular profile (40).

3. Switchgear cabinet according to one of claims 1 to 2, characterised in that at least one upper corner piece and one lower corner piece (30) of an associated side of the framework have a base body (33) connected to the plug-in member (32), which protrudes beyond the front side of the switchgear cabinet, and said corner pieces are provided with receivers or extensions for a door hinging means and/or a closure assembly, or in that the base bodies terminate flush with the front side and respectively the rear side of the framework.

4. Switchgear cabinet according to one of claims 1 to 3, characterised in that the plug-in members (32) of the corner pieces (30) extend into the base bodies (33) via shoulder portions (37).

5. Switchgear cabinet according to one of claims 1 to 4, characterised in that the horizontal and vertical frame members (10,20) are provided with longitudinal grooves (15,25), in which angled edges (54,61) of the cover (50) and of the side panels (60) engage.

6. Switchgear cabinet according to claim 5, characterised in that seals are inserted into the longitudinal grooves (15,25) of the horizontal and vertical frame members (10,20), and the edges (54,61) of the cover (50) and of the side panels (50) press upon said seals.

7. Switchgear cabinet according to one of claims 1 to 6, characterised in that the horizontal and vertical frame members (10,20) have end faces (11,21), which face towards the front side and respectively the rear side of the framework, in that the corner piece has, at its base part (33) in the region of the end faces (11,21), a flat connection face which extends into the two end faces (11,21), and in that periferal seals are mountable on the end faces (11,21) and the connection faces of the corner pieces (30) to seal the rear wall and/or the cabinet door.

8. Switchgear cabinet according to one of claims 1 to 7, characterised in that the part of the base body (33) of the corner piece (30) forming the external face(s) extends into the outwardly facing lateral faces (13,23) of the connected frame members (10,20).

## Revendications

1. Armoire de distribution comportant un cadre d'ossature consistant en un assemblage de montants d'ossature pouvant être fermé au moyen d'un panneau supérieur (50), d'éléments latéraux (60), d'un panneau arrière et d'une porte d'armoire, où les entretoises de profondeur horizontales (40) sont constituées de tronçons de profilés ouverts vers l'extérieur
caractérisée
en ce que le panneau supérieur (50) et/ou les éléments latéraux (60) présentent des parties chanfreinées (52) qui recouvrent au moins partiellement la face externe (43) des tronçons de profilés, et où il est réalisé, au moyen de la partie chanfreinée (52) et de la surface externe (43) du profilé, un logement dans lequel peut être enfiché, en guise de tenon, un embout (32) d'une pièce d'angle (30).

2. Armoire de distribution suivant la revendication 1,
caractérisée
en ce que l'entretoise de profondeur (40) a la forme d'une cornière comportant deux ailes (41, 42) auxquelles sont raccordés un montant d'ossature horizontal (10) et un montant d'ossature vertical(20), et en ce que le panneau supérieur présente une partie chanfreinée (52) qui s'étend de l'arête d'une aile (41) à celle de l'autre aile (42) de sorte qu'entre la partie chanfreinée (52) et la face externe (43) des deux ailes (41, 42) de la cornière (40), il est ménagé un logement présentant une section transversale sensiblement triangulaire.

3. Armoire de distribution suivant l'une ou l'autre des revendications 1 et 2,
caractérisée
en ce qu'au moins une pièce d'angle supérieure (30) et une pièce d'angle inférieure (30) d'un côté correspondant du cadre d'ossature présentent un corps de base (33) adjoint à l'embout (32), ce corps de base qui fait ressaut sur le plan de la face avant de l'armoire étant pourvu de logements ou d'épaulements pour une penture de porte et/ou une ou plusieurs tringle(s) de fermeture,
ou en ce que les corps de base viennent à fleur de la face avant ou de la face arrière du cadre d'ossature.

4. Armoire de distribution suivant l'une quelconque des revendications 1 à 3,
caractérisée
en ce que les embouts enfichables (32) des pièces d'angle (30) se raccordent aux corps de base (33) par l'intermédiaire d'épaulements (37) faisant ressaut.

5. Armoire de distribution suivant l'une quelconque des revendications de 1 à 4,
caractérisée
en ce que les montants d'ossature horizontaux et verticaux(10, 20) sont pourvus de rainures longitudinales (15, 25) dans lesquelles viennent s'insérer les bords coudés (54, 61) du panneau supérieur (50) et des éléments latéraux (60).

6. Armoire de distribution suivant la revendication 5,
caractérisée
en ce que dans les rainures longitudinales (15, 25) des éléments d'ossature horizontaux et verticaux (10, 20) sont posés des joints d'étanchéité sur lesquels viennent presser les bords (54, 61) du panneau supérieur (50) et des éléments latéraux (60).

7. Armoire de distribution suivant l'une quelconque des revendications de 1 à 6,
caractérisée
en ce que les montants d'ossature horizontaux et verticaux (10, 20) présentent des faces frontales (11, 21) tournées vers l'avant ou vers l'arrière du cadre d'ossature, en ce que la pièce d'angle présente sur son élément de base (33), dans la région des faces frontales (11, 21), une surface de raccordement plane se prolongeant par les deux surfaces frontales (11, 21), et
en ce que sur les surfaces frontales (11, 21) et sur les surfaces de raccordement des pièces d'angle (30) peuvent être apposés des joints périphériques assurant l'étanchéité du panneau arrière et/ou de la porte de l'armoire.

8. Armoire de distribution suivant l'une quelconque des revendications de 1 à 7,
caractérisée
en ce que la partie du corps de base (33) de la pièce d'angle (30) comprenant la/les face(s) extérieure(s) se prolonge par les faces extérieures (13,3) des montants d'ossature (10, 20) raccordés à cette pièce d'angle.
